# EUROPEAN PATENT APPLICATION

(11) **EP 3 779 264 A1**
(43) Date of publication of application: **17.02.2021**
(21) Application number: 19776782.5
(22) Date of filing: 27.03.2019
(51) Int. Cl.: F21K 9/20, F21K 9/64, C09K 11/77, C09K 11/64, F21Y 115/00, F21Y 113/13

(54) **LIGHT EMITTING APPARATUS**

(30) Priority: 27.03.2018 US 201862648454 P
(71) Applicant: Seoul Semiconductor Co., Ltd., Gyeonggi-do 15429 (KR)
(72) Inventor: HAN, Bo Yong, Ansan-si, Gyeonggi-do 15429 (KR)
(74) Representative: Stolmár & Partner Patentanwälte PartG mbB
(86) International application number: PCT/KR2019/003529
(87) International publication number: WO 2019/190179

(57) **Abstract**

A light emitting device includes a blue light emitting portion emitting blue light; a green light emitting portion emitting green light; and a red light emitting portion emitting red light, wherein the blue light emitting portion includes a near-UV light emitting diode chip and a wavelength conversion portion emitting blue light through wavelength conversion of near-UV light emitted from the near-UV light emitting diode chip, and a peak in a wavelength band corresponding to near-UV light emitted from the blue light emitting portion has an intensity in the range of 0% to 20% of intensity of a peak in a wavelength band corresponding to blue light emitted from the blue light emitting portion. The light emitting device emits white light using the blue light emitting portion, the green light emitting portion, and the red light emitting portion, thereby realizing white light having a similar spectral power distribution to that of sunlight.

## Description

### [Technical Field]

Embodiments of the present disclosure relate to a light emitting device and, more particularly, to a light emitting device that can be used in a lighting fixture using a light emitting diode as a light source.

### [Background Art]

Most life on earth has adapted to work in tune with the sun. The human body has also adapted to sunlight over a long period of time. Accordingly, human biorhythm is known to change with the change of the sunlight. Particularly, in the morning, cortisol is secreted from the human body under bright sunlight. Cortisol causes more blood to be supplied to the organs of the body to increase the pulse and respiration in response to external stimulus, such as stress, thereby causing the body to awaken and prepare for daytime activity. After active physical activity under active sunlight during the daytime, the body secretes melatonin in the evening to reduce the pulse, body temperature and blood pressure of the body, thereby assisting in resting and sleeping.

In modern society, however, most people mainly perform physical activities in the home or office instead of under sunlight. It is common that the time staying indoors at noon is longer than the time for physical activity under sunlight.

However, indoor lighting devices generally exhibit a constant spectral power distribution that significantly differs from the spectral power distribution of sunlight.

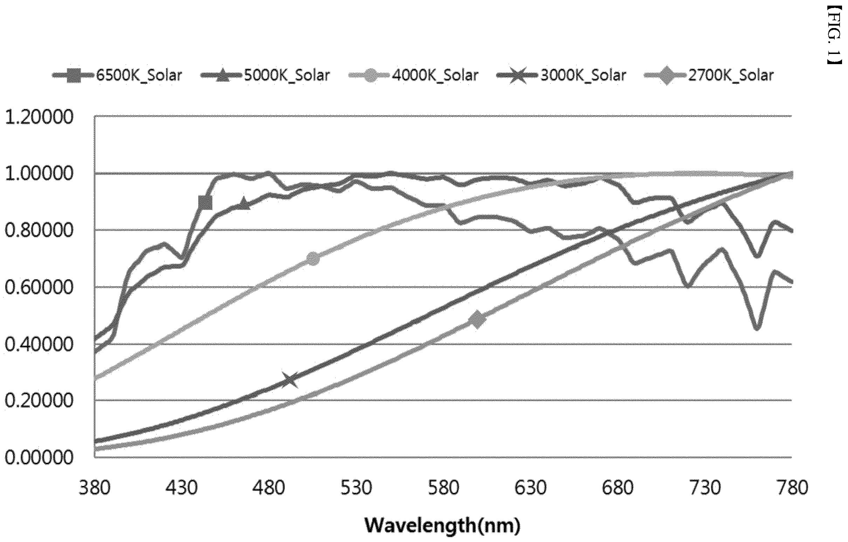

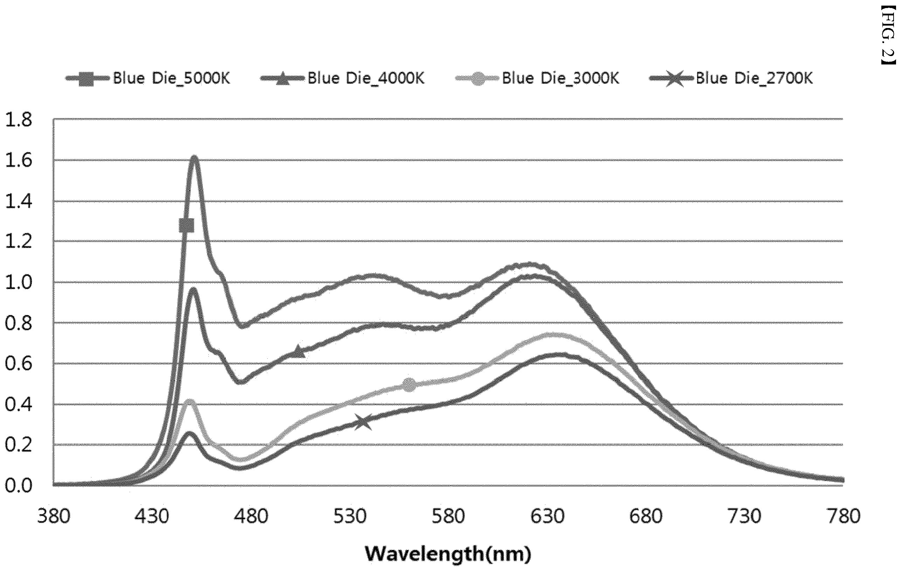

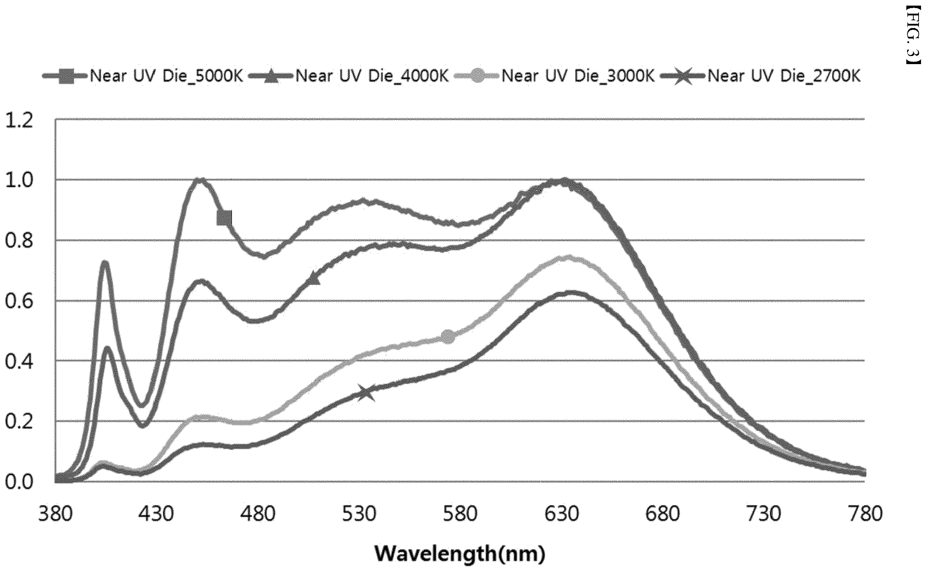

FIG. 1 is a graph depicting a spectral power distribution according to color temperature of sunlight and FIG. 2 is a graph depicting a spectral power distribution of light emitted from a white light emitting device based on a conventional blue light emitting diode chip. FIG. 3 is a graph depicting a spectral power distribution of light emitted from a white light emitting device based on a conventional near-UV light emitting diode chip.

A white light emitting device realized using a blue light emitting diode chip exhibits the color temperature-related spectral power distribution, as shown in FIG. 2. The white light emitting device using the blue light emitting diode chip exhibits a substantially uniform spectral power distribution in the overall wavelength region, but has a problem of high peaks in the wavelength region corresponding to blue light due to realization of white light based on the blue light emitting diode. The white light emitting device employing such a blue light emitting diode chip emits white light through wavelength conversion of a fraction of light emitted from the blue light emitting diode chip.

With the blue light emitting diode chip used to realize white light, the white light emitting device exhibits high peaks of blue light in the blue wavelength band, which destroys retinal cells in the human lens and affects the secretion of cortisol or melatonin in the human body, thereby causing a high risk of mental disorder, such as insomnia or bipolar disorder. In addition, the blue light causes the metabolism of the human body to become unbalanced, thereby causing adult diseases, such as obesity and diabetes.

A white light emitting device realized using a near-UV light emitting diode chip instead of the blue light emitting diode chip exhibits a spectral power distribution as shown in FIG. 3. Herein "near-UV light" means short-wavelength visible light close to UV light and a near-UV light emitting diode chip means a light emitting diode chip adapted to emit light having a peak wavelength in the range of about 390 nm to about 430 nm. FIG. 3 is a graph depicting a spectral power distribution of light emitted from a white light emitting device, which is manufactured based on a near-UV light emitting diode chip and has an average color rendering index of 95 or more, according to color temperature. From FIG. 3, it can be seen that the white light emitting device has low peaks in the wavelength band corresponding to blue light, unlike FIG. 2.

However, the near-UV light emitting diode chip has a problem of higher manufacturing costs than the blue light emitting diode chip. In addition, the white light emitting device using the near-UV light emitting diode chip requires the use of phosphors for emitting blue light, thereby providing relatively low light conversion efficiency. Moreover, when the white light emitting device based on the near-UV light emitting diode chip uses phenyl-based silicone as in the white light emitting device based on the blue light emitting diode chip, there can be a problem of deterioration in reliability such as a yellowing phenomenon due to the characteristics of light emitted from the near-UV light emitting diode chip. Thus, the white light emitting device based on the near-UV light emitting diode chip is required to use methyl-based silicone. However, the methyl-based silicone has lower strength than the phenyl-based silicone, thereby causing deterioration in reliability.

### [Disclosure]

### [Technical Problem]

Embodiments of the present disclosure provide a light emitting device capable of realizing a spectral power distribution close to the spectral power distribution of sunlight to which the human body is adapted.

Embodiments of the present disclosure provide a light emitting device capable of changing the spectral power distribution of light emitted therefrom.

### [Technical Solution]

In accordance with one embodiment of the present disclosure, a light emitting device includes: a blue light emitting portion emitting blue light; a green light emitting portion emitting green light; and a red light emitting portion emitting red light, wherein the blue light emitting portion includes a near-UV light emitting diode chip and a wavelength conversion portion emitting blue light through wavelength conversion of near-UV light emitted from the near-UV light emitting diode chip, and a peak in a wavelength band corresponding to near-UV light emitted from the blue light emitting portion has an intensity in the range of 0% to 20% of intensity of a peak in a wavelength band corresponding to blue light emitted from the blue light emitting portion.

Herein "near-UV light" means short-wavelength visible light close to UV light and refers to light having a wavelength in the range of about 390 nm to 430 nm. In addition, the "near-UV light emitting diode chip" means a light emitting diode chip adapted to emit light having a peak wavelength in the range of about 390 nm to about 430 nm. On the other hand, "blue light" means visible light having a wavelength in the range of about 430 nm to about 500 nm and the "blue light emitting diode chip" means a light emitting diode chip adapted to emit light having a peak wavelength in the range of about 430 nm to about 500 nm. Further, "green light" means visible light having a wavelength in the range of about 500 nm to about 580 nm and "red light" means visible light having a wavelength in the range of about 600 nm to about 680 nm.

The blue light emitting portion may include: a housing; the near-UV light emitting diode chip mounted on the housing; and the wavelength conversion portion disposed to cover the near-UV light emitting diode chip and containing at least one kind of phosphor emitting blue light through wavelength conversion of near-UV light emitted from the near-UV light emitting diode chip.

The phosphor may include at least one selected from the group consisting of BaMgAl₁₀O₁₇:Mn²⁺, BaMgAl₁₂O₁₉:Mn²⁺ and Sr,Ca,Ba(PO₄)Cl:Eu²⁺.

The green light emitting portion may include: a housing; a near-UV light emitting diode chip or a blue light emitting diode chip mounted on the housing; and a wavelength conversion portion disposed to cover the near-UV or blue light emitting diode chip and containing at least one kind of phosphor emitting green light through wavelength conversion of light emitted from the near-UV or blue light emitting diode chip.

A peak in a wavelength band corresponding to the near-UV or blue light emitted from the green light emitting portion may have an intensity in the range of 0% to 20% of intensity of a peak in a wavelength band corresponding to green light emitted from the green light emitting portion.

The phosphor may include at least one selected from the group consisting of LuAG (Lu₃(Al,Gd)₅O₁₂:Ce³⁺), YAG (Y₃(Al,Gd)₅O₁₂:Ce³⁺), Ga-LuAG ((Lu,Ga)₃(Al,Gd)₅O₁₂:Ce³⁺, Ga-YAG ((Ga,Y)₃(Al,Gd)₅O₁₂:Ce³⁺), LuYAG ((Lu,Y)₃(Al,Gd)₅O₁₂:Ce³⁺), orthosilicate ((Sr,Ba,Ca,Mg)₂SiO₄:Eu²⁺), oxynitride ((Ba,Sr,Ca)Si₂O₂N₂:Eu²⁺), and thiogallate (SrGa₂S₄:Eu²⁺).

The red light emitting portion may include: a housing; a near-UV light emitting diode chip or a blue light emitting diode chip mounted on the housing; and a wavelength conversion portion disposed to cover the near-UV or blue light emitting diode chip and containing at least one kind of phosphor emitting red light through wavelength conversion of light emitted from the near-UV or blue light emitting diode chip.

A peak in a wavelength band corresponding to the near-UV or blue light emitted from the red light emitting portion may have an intensity in the range of 0% to 20% of intensity of a peak in a wavelength band corresponding to red light emitted from the red light emitting portion.

The phosphor may include at least one selected from the group consisting of CASN (CaAlSiN₃:Eu²⁺), oxynitride ((Ba,Sr,Ca)₂Si₅N₈:Eu²⁺), sulfide (Ca,Sr)S₂:Eu²⁺), and thiosilicate ((Sr,Ca)₂SiS₄:Eu²⁺).

A triangular region defined by color coordinates of the blue light emitting portion, the green light emitting portion and the red light emitting portion may comprise at least some section on the Planckian locus, and a highest color temperature on the Planckian locus in the triangular region may be 5,000K, and a lowest color temperature thereon may be 3,000K or less.

Further, the highest color temperature may be 6,000K or more and the lowest color temperature may be 2,700K or less.

In addition, the highest color temperature may be 6,500K or more.

Further, the highest color temperature may be 6,500K or more and the lowest color temperature may be 1,800K or less.

A peak in a wavelength band corresponding to near-UV light or blue light emitted from the green light emitting portion may have an intensity in the range of 0% to 20% of intensity of a peak in a wavelength band corresponding to green light emitted from the green light emitting portion, and a peak in a wavelength band corresponding to near-UV light or blue light emitted from the red light emitting portion may have an intensity in the range of 0% to 20% of intensity of a peak in a wavelength band corresponding to red light emitted from the red light emitting portion.

The the light emitting device may comprise multiple blue light emitting portions, multiple green light emitting portions, and multiple red light emitting portions.

The light emitting device may further comprises a base, wherein the multiple blue, green and red light emitting portions may be arranged on the base.

The light emitting device may further comprises an IC disposed on the base.

The light emitting device may emit light based on spectrum information of sunlight stored in a database.

The light emitting device may further comprises a timer, wherein the light emitting device emit light based on the stored spectrum information of sunlight according to time of the timer.

The light emitting device may be controlled by a user interface.

### [Advantageous Effects]

Embodiments of the present disclosure provide a light emitting device that includes a blue light emitting portion, a green light emitting portion and a red light emitting portion to emit white light having a similar spectral power distribution to that of sunlight.

The light emitting device according to the embodiments can regulate the color temperature of white light emitted therefrom through regulation of electric current applied to the blue light emitting portion, the green light emitting portion and the red light emitting portion, thereby enabling emission of white light that has a color temperature varying over time or according to a user preset value and is very similar to sunlight.

### [Description of Drawings]

FIG. 1 is a graph depicting a spectral power distribution according to color temperature of sunlight.
FIG. 2 is a graph depicting a spectral power distribution of light emitted from a white light emitting device based on a conventional blue light emitting diode chip.
FIG. 3 is a graph depicting a spectral power distribution of light emitted from a white light emitting device based on a conventional near-UV light emitting diode chip.
FIG. 4 is a schematic view of a light emitting device according to one embodiment of the present disclosure.
FIG. 5 is a schematic view of a light emitting diode chip in the light emitting device according to one embodiment of the present disclosure.
FIG. 6 is a graph depicting spectral power distributions of blue light, green light and red light emitted from the light emitting device according to the embodiment of the present disclosure.
FIG. 7 is a graph depicting spectral power distributions of light emitted from the light emitting device according to the embodiment of the present disclosure depending upon electric current supplied thereto.
FIG. 8 is a graph depicting spectral power distributions of light emitted from the light emitting device according to the embodiment of the present disclosure depending upon color temperature.
FIG. 9 shows schematic color coordinates for illustrating the light emitting device according to the embodiment of the present disclosure.
FIG. 10 shows schematic color coordinates for illustrating a light emitting device according to another embodiment of the present disclosure.
FIG. 11 shows schematic color coordinates for illustrating a light emitting device according to a further embodiment of the present disclosure.

### [Best Mode]

Hereinafter, embodiments of the present disclosure will be described in detail with reference to the accompanying drawings.

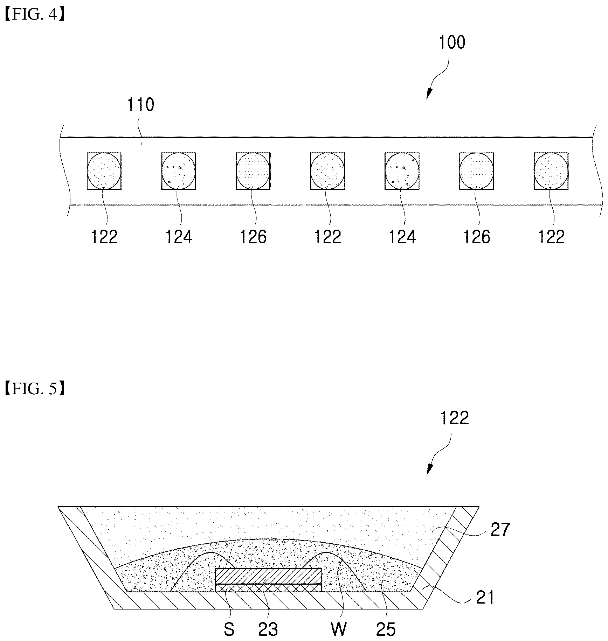

FIG. 4 is a schematic view of a light emitting device according to one embodiment of the present disclosure and FIG. 5 is a schematic view of a light emitting diode chip in the light emitting device according to one embodiment of the present disclosure.

Referring to FIG. 4, a light emitting device 100 according to one embodiment includes a base 110, a first light emitting portion, a second light emitting portion, and a third light emitting portion.

The first light emitting portion may be a blue light emitting portion 122, the second light emitting portion may be a green light emitting portion 124, and the third light emitting portion may be a red light emitting portion 126.

The blue light emitting portion 122, the green light emitting portion 124, and the red light emitting portion 126 may be mounted on the base 110. In addition, although a separate circuit is not formed on the base 110 of FIG. 4, the base 110 may be a printed circuit board including a circuit for supplying power to the blue light emitting portion 122, the green light emitting portion 124 and the red light emitting portion 126, and may be provided with an integrated circuit (IC) for supplying power to the base 100, as needed.

The blue light emitting portion 122 may include a near-UV light emitting diode chip and may emit blue light through wavelength conversion of near-UV light emitted from the near-UV light emitting diode chip. Details of the blue light emitting portion 122 will be described below.

The green light emitting portion 124 may include a near-UV light emitting diode chip or a blue light emitting diode chip and may emit green light through wavelength conversion of light emitted from the near-UV or blue light emitting diode chip.

The red light emitting portion 126 may include a near-UV light emitting diode chip or a blue light emitting diode chip and may emit red light through wavelength conversion of light emitted from the near-UV or blue light emitting diode chip.

In this embodiment, each of the blue light emitting portion 122, the green light emitting portion 124, and the red light emitting portion 126 may be provided in plural, and the blue light emitting portion 122, the green light emitting portion 124, and the red light emitting portion 126 may be sequentially arranged, as shown in FIG. 1, without being limited thereto. It should be understood that the blue light emitting portion 122, the green light emitting portion 124, and the red light emitting portion 126 may be arranged in other sequences. In addition, although multiple blue light emitting portions 122, multiple green light emitting portions 124, and multiple red light emitting portions 126 are illustrated as being individually disposed in this embodiment, the multiple blue light emitting portions 122, the multiple green light emitting portions 124, and the multiple red light emitting portions 126 may be arranged in groups. Further, the multiple blue light emitting portions 122, the multiple green light emitting portions 124, and the multiple red light emitting portions 126 arranged in groups may be disposed on the base 110.

Next, details of the blue light emitting portion 122, the green light emitting portion 124, and the red light emitting portion 126 will be described in detail with reference to FIG. 4. Here, the blue light emitting portion 122 shown in FIG. 5 will be representatively described by way of example.

Referring to FIG. 5, according to this embodiment, the blue light emitting portion 122 includes a housing 21, a light emitting diode chip 23, a wavelength conversion portion 25, and a molding portion 27.

The housing 21 receives the light emitting diode chip 23 therein and may include at least one lead therein. The housing 21 may have a cavity open at one side thereof and the light emitting diode chip 23 may be disposed inside the cavity.

FIG. 5 illustrates the blue light emitting portion 122, in which the light emitting diode chip 23 may be a near-UV light emitting diode chip and may be disposed at a lower portion inside the cavity of the housing 21. The light emitting diode chip 23 may be bonded to the housing 21 by a bonding portion S and may be electrically connected to at least one lead of the housing 21 by a wire W. Here, the bonding portion S may include silver (Ag) pastes, without being limited thereto.

The wavelength conversion portion 25 is disposed inside the cavity of the housing 21 to cover the light emitting diode chip 23. The wavelength conversion portion 25 may include at least one kind of phosphor for wavelength conversion of near-UV light, which is emitted from the near-UV light emitting diode chip used in the blue light emitting portion 122, into blue light (for example, light in a wavelength band of 430 nm to 500 nm). According to this embodiment, as the phosphor for wavelength conversion of near-UV light into blue light, BAM-based phosphors and halo-phosphate-based phosphors may be used. For example, the phosphor for wavelength conversion of near-UV light into blue light may include at least one selected from the group consisting of BaMgAl₁₀O₁₇:Mn²⁺ BaMgAl₁₂O₁₉:Mn²⁺ and Sr,Ca,Ba(PO₄)Cl:Eu²⁺.

The molding portion 27 is formed in the cavity of the housing 21 to cover the wavelength conversion portion 25. In this embodiment, the molding portion 27 may be formed of phenyl-based silicone.

Although the molding portion 27 is illustrated as being formed to cover the wavelength conversion portion 25 in this embodiment, the molding portion 27 may be integrally formed with the wavelength conversion portion 25.

According to this embodiment, the light emitting diode chip 23 of the blue light emitting portion 122 may be a lateral type light emitting diode chip. Alternatively, a vertical light emitting diode chip or a flip-chip type light emitting diode chip may be used as the light emitting diode chip.

In addition, according to this embodiment, in the green light emitting portion 124, the light emitting diode chip 23 may be a near-UV light emitting diode chip or a blue light emitting diode chip and the wavelength conversion portion 25 may emit green light (for example, light in a wavelength band of 500 nm to 580 nm) through wavelength conversion of light emitted from the near-UV or blue light emitting diode chip. To this end, the wavelength conversion portion 25 may include at least one kind of phosphor for wavelength conversion of near-UV light or blue light into green light. According to this embodiment, as the phosphor for wavelength conversion of near-UV light or blue light into green light, LuAG, YAG, silicate, sulfide and oxynitride-based phosphors may be used. For example, the phosphor for wavelength conversion of near-UV light or blue light into green light may include at least one selected from the group consisting of LuAG (Lu₃(Al,Gd)₅O₁₂:Ce³⁺), YAG (Y₃(Al,Gd)₅O₁₂:Ce³⁺), Ga-LuAG ((Lu,Ga)₃(Al,Gd)₅O₁₂:Ce³⁺, Ga-YAG ((Ga,Y)₃(Al,Gd)₅O₁₂:Ce³⁺), LuYAG ((Lu,Y)₃(Al,Gd)₅O₁₂:Ce³⁺), orthosilicate ((Sr,Ba,Ca,Mg)₂SiO₄:Eu²⁺), oxynitride ((Ba,Sr,Ca)Si₂O₂N₂:Eu²⁺), and thiogallate (SrGa₂S₄:Eu²⁺).

In addition, according to this embodiment, in the red light emitting portion 126, the light emitting diode chip 23 may be a near-UV light emitting diode chip or a blue light emitting diode chip and the wavelength conversion portion 25 may emit red light (for example, light in a wavelength band of 600 nm to 680 nm) through wavelength conversion of light emitted from the near-UV or blue light emitting diode chip. To this end, the wavelength conversion portion 25 may include at least one kind of phosphor for wavelength conversion of near-UV light or blue light into red light. According to this embodiment, as the phosphor for wavelength conversion of near-UV light or blue light into red light, CASN, sulfide, fluoride and oxynitride phosphors may be used. For example, the phosphor for wavelength conversion of near-UV light or blue light into red light may include at least one selected from the group consisting of CASN (CaAlSiN₃:Eu²⁺), oxynitride ((Ba,Sr,Ca)₂Si₅N₈:Eu²⁺), sulfide (Ca,Sr)S₂:Eu²⁺) and thiosilicate ((Sr,Ca)₂SiS₄:Eu²⁺).

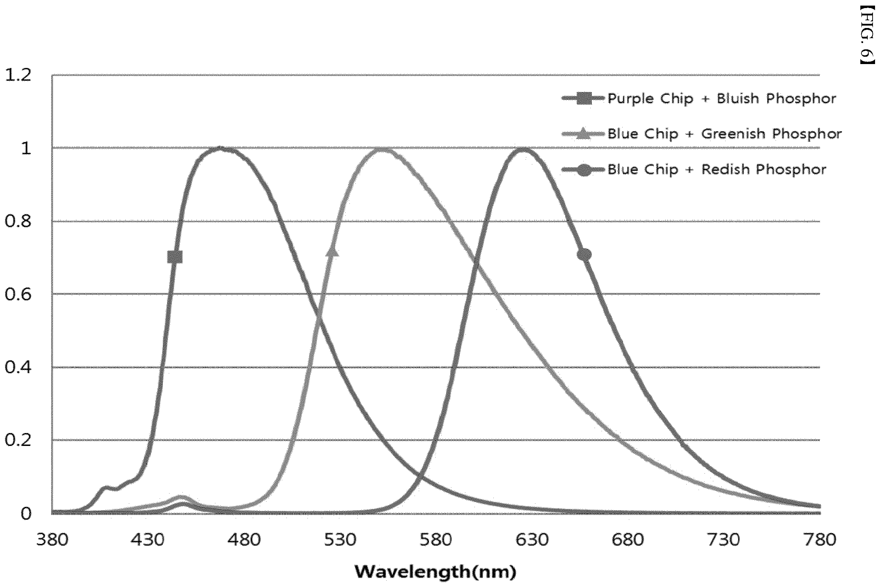

FIG. 6 is a graph depicting spectral power distributions of blue light, green light and red light emitted from the light emitting device according to the embodiment of the present disclosure.

Referring to FIG. 6, in the spectral power distribution of blue light emitted from the blue light emitting portion 122, it can be seen that peaks appear in the wavelength band of blue light. In this embodiment, since the blue light emitting portion 122 adopts the near-UV light emitting diode chip, some peaks appear in the wavelength band of near-UV light.

In this spectral power distribution, the peaks in the wavelength band of near-UV light may have an intensity in the range of 0% to 20% of the intensity of the peaks in the wavelength band of blue light. Furthermore, the peaks in the wavelength band of near-UV light have an intensity in the range of 0% to 10% of the intensity of the peaks in the wavelength band of blue light. The lower intensity of the peaks in the wavelength band of near-UV light than the intensity of the peaks in the wavelength of blue light is caused by the structure wherein the wavelength conversion portion 25 adapted to perform wavelength conversion of near-UV light emitted from the near-UV light emitting diode chip contains a relatively large amount of phosphors to achieve wavelength conversion of near-UV light into blue light as much as possible. Thus, the light emitting device according to this embodiment does not require a separate color filter for shielding near-UV light, thereby improving luminous efficacy as compared with a light emitting device using the color filter. The intensity of the peaks in the wavelength band of near-UV light (about 380 nm to about 430 nm) emitted from the blue light emitting portion 122 may be regulated within the above range according to correlated color temperature information of sunlight.

Further, in the spectral power distribution of green light emitted from the green light emitting portion 124, it can be seen that peaks appear in the wavelength band of green light. In this embodiment, since the green light emitting portion 124 adopts the blue light emitting diode chip, some peaks appear in the wavelength band of blue light. In the structure wherein the green light emitting portion 124 adopts a near-UV light emitting diode chip, a peak may appear in the wavelength band of near-UV light.

In this spectral power distribution, the peaks in the wavelength band of near-UV light or blue light may have an intensity in the range of 0% to 20% of the intensity of the peaks in the wavelength band of green light. Furthermore, the peaks in the wavelength band of near-UV light or blue light have an intensity in the range of 0% to 10% of the intensity of the peaks in the wavelength band of green light. The lower intensity of the peaks in the wavelength band of near-UV light or blue light than the intensity of the peaks in the wavelength of green light is caused by the structure wherein the wavelength conversion portion 25 adapted to perform wavelength conversion of light emitted from the near-UV or blue light emitting diode chip contains a relatively large amount of phosphors to achieve wavelength conversion of near-UV light or blue light into green light as much as possible.

Further, in the spectral power distribution of red light emitted from the red light emitting portion 126, it can be seen that peaks appear in the wavelength band of red light. In this embodiment, since the red light emitting portion 126 adopts the blue light emitting diode chip, some peaks appear in the wavelength band of blue light. In the structure wherein the red light emitting portion 126 adopts a near-UV light emitting diode chip, a peak may appear in the wavelength band of near-UV light.

In this spectral power distribution, the peaks in the wavelength band of near-UV light or blue light may have an intensity in the range of 0% to 20% of the intensity of the peaks in the wavelength band of red light. Preferably, the peaks in the wavelength band of near-UV light or blue light have an intensity in the range of 0% to 10% of the intensity of the peaks in the wavelength band of red light. The lower intensity of the peaks in the wavelength band of near-UV light or blue light than the intensity of the peaks in the wavelength of red light is caused by the structure wherein the wavelength conversion portion 25 adapted to perform wavelength conversion of light emitted from the near-UV or blue light emitting diode chip contains a relatively large amount of phosphors to achieve wavelength conversion of near-UV light or blue light into red light as much as possible.

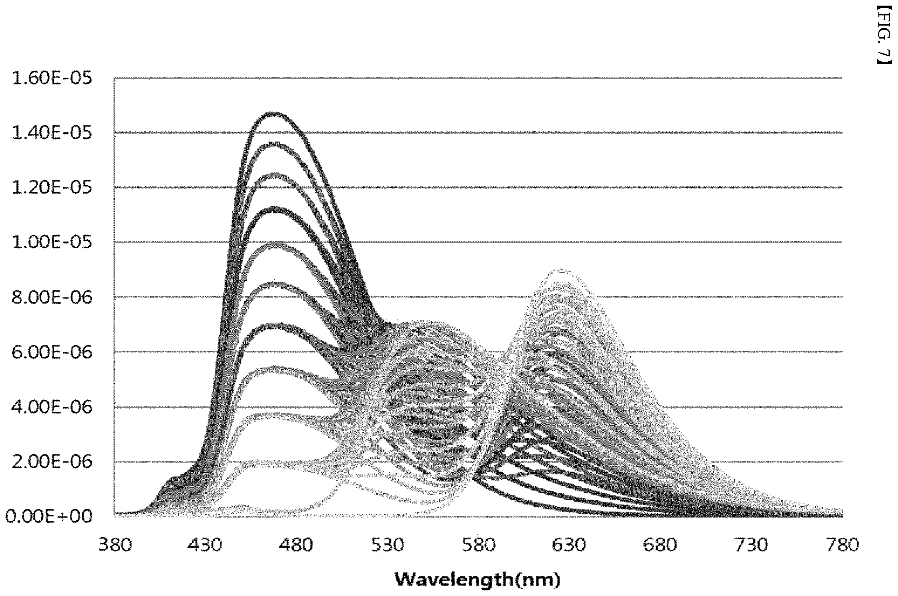

FIG. 7 is a graph depicting spectral power distributions of light emitted from the light emitting device according to the embodiment of the present disclosure depending upon condition of electric current supplied thereto.

According to this embodiment, each of the blue light emitting portion 122, the green light emitting portion 124, and the red light emitting portion 126 may be independently driven. That is, anodes and cathodes of the blue light emitting portion 122, the green light emitting portion 124, and the red light emitting portion 126 are individually electrically connected to a power source. The graph of FIG. 7 depicts spectral power distributions of light emitted from the light emitting device 100 through individual regulation of electric current supplied to the blue light emitting portion 122, the green light emitting portion 124, and the red light emitting portion 126. From this graph, it can be seen that the peaks in the wavelength bands of blue light, green light and red light differ depending upon electric current supplied thereto. In addition, the intensity of the peaks in the wavelength band of about 380 nm to about 430 nm may be regulated according to correlated color temperature information of sunlight.

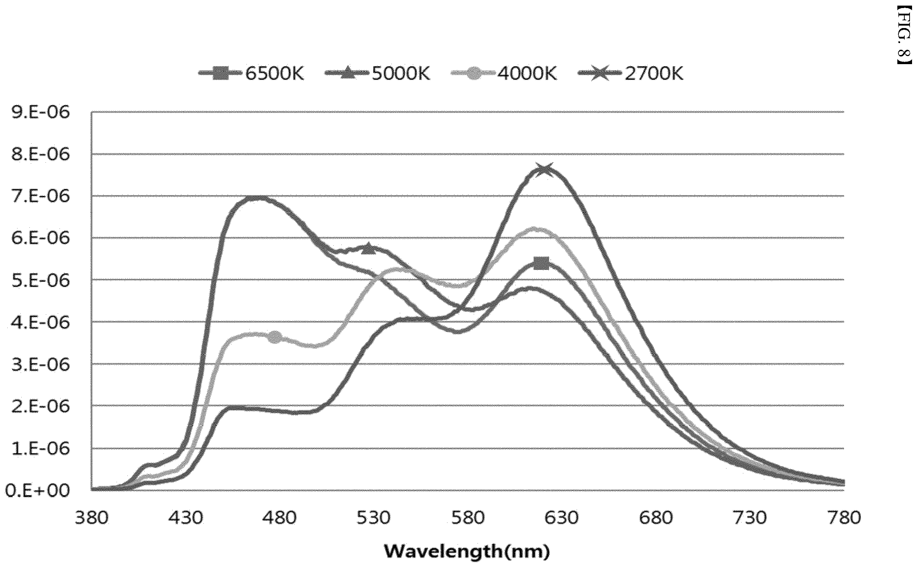

FIG. 8 is a graph depicting spectral power distributions of light emitted from the light emitting device according to the embodiment of the present disclosure depending upon color temperature.

Referring to FIG. 8, spectral power distributions of white regions corresponding to 6,500K, 5,000K, 4,500K and 2,700K, which are representative color temperatures on CIE-1931 xy color coordinates regulated by the American National Standards Institute (ANSI), can be obtained by controlling electric current supplied to the blue light emitting portion 122, the green light emitting portion 124, and the red light emitting portion 126 in the light emitting device 100 according to this embodiment.

Comparing with the spectral power distribution of a white light emitting device based on a conventional blue light emitting diode chip shown in FIG. 2, it can be seen that the graph of FIG. 8 exhibits a broader spectrum of the wavelength band of near-UV light or blue light. Further, it can be seen that the intensity of light emitted from the light emitting diode in the graph of FIG. 8 is lowered to a substantially similar level to the intensity of sunlight in the spectral power distribution of sunlight shown in FIG. 1.

Further, comparing the graph of FIG. 8 with the spectral power distribution of a conventional near-UV light emitting diode chip shown in FIG. 3, it can be seen that the graph of FIG. 8 exhibits lower intensity of light in the wavelength band of near-UV light and a broader width of the wavelength band of blue light.

Thus, the light emitting device 100 according to this embodiment can exhibit a more uniform and continuous spectral power distribution of white light emitted therefrom than a conventional light emitting device.

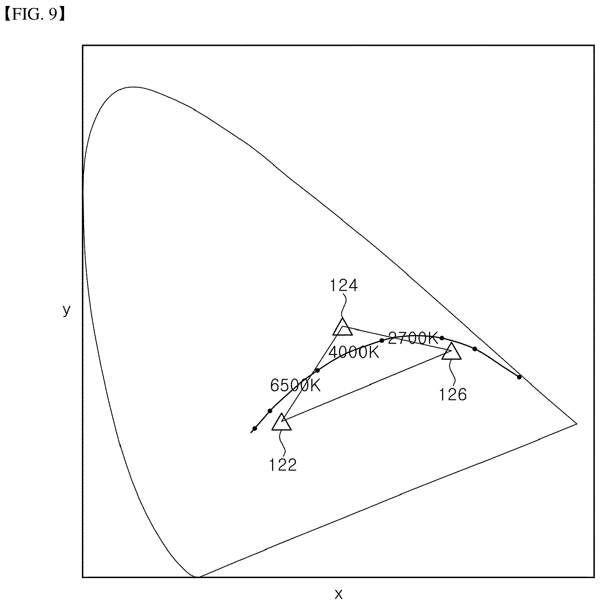

FIG. 9 to FIG. 11 are schematic color coordinates for illustrating the light emitting device 100 according to the embodiment of the present disclosure.

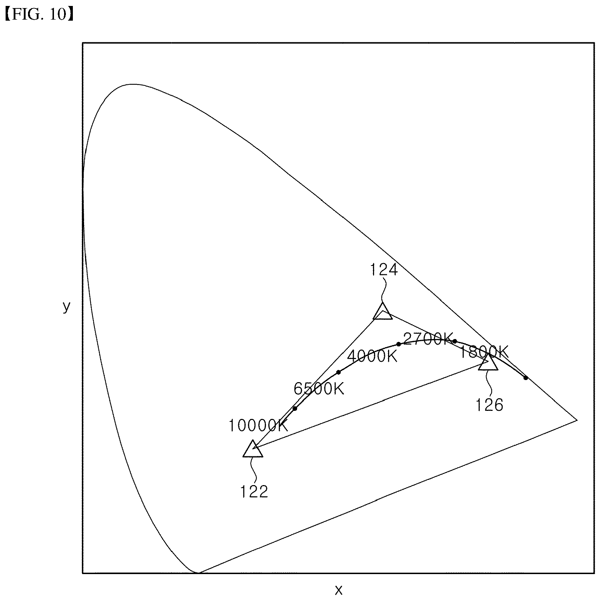

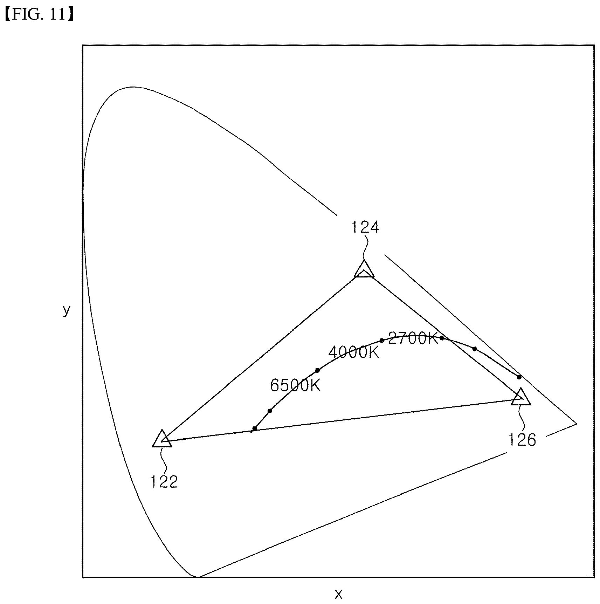

Referring to FIG. 9 to FIG. 11, a triangle is defined inside the color coordinates by the blue light emitting portion 122, the green light emitting portion 124 and the red light emitting portion 126, in which at least a portion of the Planckian locus is included in the triangle. The size of the triangle may be regulated by regulating the color coordinates of the blue light emitting portion 122, the green light emitting portion 124 and the red light emitting portion 126, thereby enabling regulation of the length of the Planckian locus included in the triangle. FIG. 9 shows a triangle including the Planckian locus having a relatively short length, FIG. 10 shows a triangle including the Planckian locus having a relatively long length, and FIG. 11 shows a triangle defined by the color coordinates of the blue, green and red light emitting portions 122, 124, 126 shown in FIG. 6.

Unless specifically stated otherwise, the Planckian locus means the Planckian locus in the CIE-1931 color coordinate system regulated by American National Standards Institute (ANSI). The CIE-1931 color coordinate system can be easily converted into the 1976 coordinate system through simple numerical modification.

Light in a triangle, particularly light having a color temperature on the Planckian locus included in the triangle, can be realized by regulating brightness of light emitted from the blue light emitting portion 122, the green light emitting portion 124 and the red light emitting portion 126.

The highest color temperature and the lowest color temperature on the Planckian locus included in the triangle restrict a color temperature of white light that can be realized. In order to realize light similar to sunlight, on the Planckian locus in the triangle defined by the color coordinates of the blue light emitting portion 122, the green light emitting portion 124 and the red light emitting portion 126, the light emitting device may emit light having the highest color temperature of 5,000K or more and the lowest color temperature of 3,000K or less. Furthermore, the highest color temperature may be 6,000K or more, specifically 6,500K or more, more specifically 10,000K or more, and the lowest color temperature may be 2,700K or less, specifically 1,800K or less.

The light emitting device 100 according to this embodiment includes the blue light emitting portion 122, the green light emitting portion 124, and the red light emitting portion 126 and may emit white light corresponding to color temperatures of 6,500K, 5,000K, 4,500K and 2,700K through regulation of electric current supplied to each of the blue light emitting portion 122, the green light emitting portion 124, and the red light emitting portion 126. Further, upon emission of light with the same brightness, the light emitting device 100 may emit light having the color temperature of white light, with all of the blue light emitting portion 122, the green light emitting portion 124, and the red light emitting portion 126 turned on to emit light. Accordingly, it is possible to reduce the number of blue light emitting portions 122, green light emitting portions 124, and red light emitting portions 126 included in the light emitting device 100 according to this embodiment, as compared with the case of realizing color temperatures of 6,500K, 4,500K and 2,700K using white light emitting diodes emitting light having color temperatures of 6,500K and 2,700K.

By way of example, a structure for realizing white light having a luminance of 630 to 640 lm using white light emitting diodes emitting light having color temperatures of 6,500K and 2,700K will be described. Here, a near-UV light emitting diode chip has an operating voltage of about 3V and one white light emitting diode for each color temperature has a luminous efficacy of 120 lm/W. Thus, a white light emitting diode of a total 5.3W level is required. Accordingly, when electric current applied to each white light emitting diode is 62 mA, a total of 27 white light emitting diodes are required for a luminance of 630 to 640 lm. Thus, a total of 54 white light emitting diodes are required for realization of each of 6,500K and 2,700K.

According to this embodiment, since the light emitting device 100 enables regulation of the color temperature of mixed white light according to electric current supplied to the blue light emitting portion 122, the green light emitting portion 124, and the red light emitting portion 126, the blue light emitting portion 122, the green light emitting portion 124, and the red light emitting portion 126 are each provided nine in number. Accordingly, the light emitting device 100 according to this embodiment can reduce the number of light emitting portions, as compared with a conventional light emitting device, while emitting light with the same brightness.

According to this embodiment, electric current supplied to the blue light emitting portion 122, the green light emitting portion 124, and the red light emitting portion 126 may be controlled by a pulse width modulation (PWM) or TRIAC type dimming technique.

Pulse width modulation means a modulation process of changing the width of a pulse according to the magnitude of a modulation signal. For example, when the amplitude of a signal wave is large, the width of the pulse becomes wider, and when the amplitude of the signal wave is small, the width of the pulse becomes narrow. Accordingly, brightness of each of the blue light emitting portion 122, the green light emitting portion 124, and the red light emitting portion 126 can be controlled by controlling pulse widths of electric current supplied to the blue light emitting portion 122, the green light emitting portion 124, and the red light emitting portion 126, thereby achieving color temperature control.

The light emitting device 100 according to this embodiment may further include a database containing information corresponding to the morning, lunch, and evening spectra of sunlight. Thus, the light emitting device 100 may implement an emission spectrum according to a corresponding time zone of the spectrum of sunlight stored in the database.

For example, the light emitting device may emit light having a spectrum that coincides with a morning spectrum of sunlight in the morning, may emit light having a spectrum that coincides with a lunch spectrum of sunlight at lunchtime, and may emit light having a spectrum that coincides with an evening spectrum of sunlight in the evening.

Such time-based spectrum control may be changed according to user selection. That is, if a user prefers the morning spectrum of sunlight, it can be continuously used. Similarly, if a user prefers the evening spectrum of sunlight, it can be continuously used. The light emitting device allows a user to selectively use the spectrum control at breakfast and lunch only, at morning and evening only, or at lunch and dinner, as needed. Further, the light emitting device allows control of the driving time of the morning, lunch and evening spectra according to user preset time.

Such spectrum control may be properly performed not only by a timer included in the light emitting device 100, but also by user selection through a user interface.

First, when controlled by the timer, the emission spectrum of the light emitting device 100 according to this embodiment may be controlled using the stored spectrum data of sunlight according to time of the timer. Specifically, assuming that a user presets the morning spectrum from 6:00 am to 11:59 pm, the lunch spectrum from 12:00 pm to 5:59 pm, and the evening spectrum from 6:00 pm to 5:59 am in the next morning, the emission spectrum of the light emitting device 100 according to this embodiment may be controlled corresponding to the time.

When controlled by the user interface, the emission spectrum of the light emitting device 100 may be controlled using a control panel of the light emitting device 100 or a separate remote controller separated from the control panel.

Although some exemplary embodiments have been described above, it should be understood that these embodiments are given by way of illustration only, and that various modifications, variations, changes, and alterations can be made by those skilled in the art. The scope of the present disclosure should be limited only by
the accompanying claims and equivalents thereto.

## Claims

1. A light emitting device comprising:
a blue light emitting portion emitting blue light;
a green light emitting portion emitting green light; and
a red light emitting portion emitting red light,
wherein the blue light emitting portion comprises a near-UV light emitting diode chip and a wavelength conversion portion emitting blue light through wavelength conversion of near-UV light emitted from the near-UV light emitting diode chip, and
a peak in a wavelength band corresponding to near-UV light emitted from the blue light emitting portion has an intensity in the range of 0% to 20% of intensity of a peak in a wavelength band corresponding to blue light emitted from the blue light emitting portion.

2. The light emitting device according to claim 1, wherein the blue light emitting portion comprises:
a housing;
the near-UV light emitting diode chip mounted on the housing; and
the wavelength conversion portion disposed to cover the near-UV light emitting diode chip and containing at least one kind of phosphor emitting blue light through wavelength conversion of near-UV light emitted from the near-UV light emitting diode chip.

3. The light emitting device according to claim 2, wherein the phosphor comprises at least one selected from the group consisting of BaMgAl₁₀O₁₇:Mn²⁺, BaMgAl₁₂O₁₉:Mn²⁺, and Sr,Ca,Ba(PO₄)Cl:Eu²⁺.

4. The light emitting device according to claim 1, wherein the green light emitting portion comprises:
a housing;
a near-UV light emitting diode chip or a blue light emitting diode chip mounted on the housing; and
a wavelength conversion portion disposed to cover the near-UV or blue light emitting diode chip and containing at least one kind of phosphor emitting green light through wavelength conversion of light emitted from the near-UV or blue light emitting diode chip.

5. The light emitting device according to claim 4, wherein a peak in a wavelength band corresponding to near-UV light or blue light emitted from the green light emitting portion has an intensity in the range of 0% to 20% of intensity of a peak in a wavelength band corresponding to green light emitted from the green light emitting portion.

6. The light emitting device according to claim 4, wherein the phosphor comprises at least one selected from the group consisting of LuAG (Lu₃(Al,Gd)₅O₁₂:Ce³⁺), YAG (Y₃(Al,Gd)₅O₁₂:Ce³⁺), Ga-LuAG ((Lu,Ga)₃(Al,Gd)₅O₁₂:Ce³⁺, Ga-YAG ((Ga,Y)₃(Al,Gd)₅O₁₂:Ce³⁺), LuYAG ((Lu,Y)₃(Al,Gd)₅O₁₂:Ce³⁺), orthosilicate ((Sr,Ba,Ca,Mg)₂SiO₄:Eu²⁺), oxynitride ((Ba,Sr,Ca)Si₂O₂N₂:Eu²⁺), and thiogallate (SrGa₂S₄:Eu²⁺).

7. The light emitting device according to claim 1, wherein the red light emitting portion comprises:
a housing;
a near-UV light emitting diode chip or a blue light emitting diode chip mounted on the housing; and
a wavelength conversion portion disposed to cover the near-UV or blue light emitting diode chip and containing at least one kind of phosphor emitting red light through wavelength conversion of light emitted from the near-UV or blue light emitting diode chip.

8. The light emitting device according to claim 7, wherein a peak in a wavelength band corresponding to near-UV light or blue light emitted from the red light emitting portion has an intensity in the range of 0% to 20% of intensity of a peak in a wavelength band corresponding to red light emitted from the red light emitting portion.

9. The light emitting device according to claim 6, wherein the phosphor comprises at least one selected from the group consisting of CASN (CaAlSiN₃:Eu²⁺), oxynitride ((Ba,Sr,Ca)₂Si₅N₈:Eu²⁺), sulfide (Ca,Sr)S₂:Eu²⁺), and thiosilicate ((Sr,Ca)₂SiS₄:Eu²⁺).

10. The light emitting device according to claim 1, wherein a triangular region defined by color coordinates of the blue light emitting portion, the green light emitting portion and the red light emitting portion comprise at least some section on the Planckian locus,
the highest color temperature on the Planckian locus in the triangular region being 5,000K,
the lowest color temperature thereon being 3,000K or less.

11. The light emitting device according to claim 10, wherein the highest color temperature is 6,000K or more and the lowest color temperature is 2,700K or less.

12. The light emitting device according to claim 11, wherein the highest color temperature is 6,500K or more.

13. The light emitting device according to claim 12, wherein the highest color temperature is 6,500K or more and the lowest color temperature is 1,800K or less.

14. The light emitting device according to claim 10, wherein a peak in a wavelength band corresponding to near-UV light or blue light emitted from the green light emitting portion has an intensity in the range of 0% to 20% of intensity of a peak in a wavelength band corresponding to green light emitted from the green light emitting portion, and
a peak in a wavelength band corresponding to near-UV light or blue light emitted from the red light emitting portion has an intensity in the range of 0% to 20% of intensity of a peak in a wavelength band corresponding to red light emitted from the red light emitting portion.

15. The light emitting device according to claim 1, wherein the light emitting device comprises: multiple blue light emitting portions, multiple green light emitting portions, and multiple red light emitting portions.

16. The light emitting device according to claim 15, further comprising:
a base,
wherein the multiple blue, green and red light emitting portions are arranged on the base.

17. The light emitting device according to claim 16, further comprising: an IC disposed on the base.

18. The light emitting device according to claim 16, wherein the light emitting device emit light based on spectrum information of sunlight stored in a database.

19. The light emitting device according to claim 18, further comprising:
a timer,
wherein the light emitting device emit light based on the stored spectrum information of sunlight according to time of the timer.

20. The light emitting device according to claim 18, wherein the light emitting device is controlled by a user interface.
